(19) Europäisches Patentamt / European Patent Office / Office européen des brevets

(11) **EP 3 048 082 B1**

(12) **EUROPEAN PATENT SPECIFICATION**

(45) Date of publication and mention
of the grant of the patent:
**02.05.2018 Bulletin 2018/18**

(21) Application number: **13874857.9**

(22) Date of filing: **05.09.2013**

(51) Int Cl.:
**C01G 23/053** (2006.01)    **H01M 4/485** (2010.01)

(86) International application number:
**PCT/JP2013/073944**

(87) International publication number:
**WO 2015/033421 (12.03.2015 Gazette 2015/10)**

(54) **ULTRAFINE PARTICLES OF TITANIUM DIOXIDE AND METHOD FOR PRODUCING SAME**

ULTRAFEINE PARTIKEL AUS TITANDIOXID UND VERFAHREN ZUR HERSTELLUNG DAVON

PARTICULES ULTRAFINES DE DIOXYDE DE TITANE ET PROCÉDÉ DE PRODUCTION CORRESPONDANT

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**27.07.2016 Bulletin 2016/30**

(73) Proprietor: **Showa Denko K.K.**
**Tokyo 105-8518 (JP)**

(72) Inventors:
• **MIZUE, Kei**
**Toyama-shi**
**Toyama 931-8577 (JP)**

• **SANBAYASHI, Masayuki**
**Toyama-shi**
**Toyama 931-8577 (JP)**

(74) Representative: **Strehl Schübel-Hopf & Partner**
**Maximilianstrasse 54**
**80538 München (DE)**

(56) References cited:
| | |
|---|---|
| **EP-A1- 2 527 299** | **CN-B- 102 219 255** |
| **JP-A- H11 171 543** | **JP-A- 2002 154 824** |
| **JP-A- 2003 327 432** | **JP-A- 2005 289 674** |
| **JP-A- 2006 083 363** | **JP-A- 2010 514 654** |
| **US-A1- 2010 317 766** | |

**Description**

TECHNICAL FIELD

The present invention relates to ultrafine particles of titanium dioxide which are suitably used as a photocatalyst, a material for solar batteries, a raw material of an electrode material of lithium ion batteries such as lithium titanate ($Li_4Ti_5O_{12}$) and a raw material of dielectrics such as barium titanate ($BaTiO_3$) and a process for producing the ultrafine particles of titanium dioxide, as well as a composition, a material for solar batteries, a raw material of an electrode material for lithium ion batteries and a raw material of dielectrics which contain the ultrafine particles of titanium dioxide.

BACKGROUND ART

Titanium oxide has been used in the extremely extensive industrial application fields including typically additives for cosmetics, ultraviolet shielding materials, silicone rubbers or the like. In recent years, titanium oxide has also been used in various applications such as a photocatalyst, a material for solar batteries, a raw material of an electrode material for lithium ion batteries and a raw material of dielectrics.

As the electrode material for lithium ion batteries or the raw material of high-performance dielectrics, there have been noticed ultrafine particles of titanium dioxide. In general, the range of a primary particle diameter of the ultrafine particles of titanium dioxide is not clearly defined. Meanwhile, although fine particles having a particle size of 100 nm or less are usually referred to as "ultrafine particles", the ultrafine particles of titanium dioxide according to the present invention mean titanium dioxide having an average primary particle diameter ($D_{BET}$) of from 2 to 20 nm in terms of a BET specific surface area thereof as described hereinafter.

For example, $Li_4Ti_5O_{12}$ as a typical negative electrode material for lithium ion batteries is in general produced by a solid state reaction between a lithium raw material and titanium dioxide. More specifically, $Li_4Ti_5O_{12}$ is produced through a step of uniformly mixing the lithium raw material and titanium dioxide, a step of drying the resulting mixture, and a step of heat-treating the dried product.

In the mixing step, a solution prepared by dispersing the lithium raw material in water is mixed with titanium dioxide. As the lithium raw material, there may be used lithium hydroxide, lithium oxide, lithium carbonate or the like. Also, it has been reported that as the titanium dioxide, anatase-type titanium dioxide or hydrous titanium oxide are preferably used as compared to rutile-type titanium dioxide because of a good reactivity of the former titanium dioxides.

In addition, titanium dioxide has been noticed, in particular, as a raw material of high-performance dielectrics, and has been used, for example, as a raw material of $BaTiO_3$. $BaTiO_3$ is used as a constituting material of a dielectric layer of a laminated ceramic capacitor. $BaTiO_3$ is obtained by conducting the following reaction under heating.

$$BaCO_3 + TiO_2 \rightarrow BaTiO_3 + CO_2$$

The above reaction is a solid state reaction. It has been reported that in the above solid state reaction, $BaCO_3$ is decomposed at a high temperature to produce $BaO$, and then $BaO$ is diffused in $TiO_2$ particles and forms a solid solution therewith to thereby produce $BaTiO_3$. Therefore, the size of $BaTiO_3$ particles is influenced by the size of the $TiO_2$ particles as the raw material.

In recent years, with the reduction in size of laminated ceramic capacitors, there is a demand for provision of a thin dielectric layer, so that it has been inevitably required to further reduce the size of $BaTiO_3$ particles. For this reason, the reduction in size of TiO2 as a raw material of the $BaTiO_3$ particles has also been required.

Titanium dioxide can be used in various application fields as described above. However, in order to allow titanium dioxide to well exhibit its functions, it is important that titanium dioxide has a good dispersibility.

For example, in the above solid state reaction between the lithium raw material and titanium dioxide, a reactivity of these materials and a variation of a quality of the resulting product may be determined by a mixing condition of both the materials. Therefore, it is required that titanium dioxide has a less aggregating property and a high dispersibility. In the case of titanium dioxide having a poor dispersibility, it is required to subject the aggregated titanium dioxide particles to deaggregation step, so that there tends to arise problems such as need of excessively large energy for the deaggregation step, inclusion of wear debris in the resulting particles, and unevenness of sizes of the particles. In addition, when using titanium dioxide as a photocatalyst, it is also required that titanium dioxide has a high dispersibility. If titanium dioxide is deteriorated in dispersibility, an opacifying power becomes strong. As a result, an application of the titanium dioxide is limited. In the application field of solar batteries, light tends to be hardly transmitted through titanium dioxide having a poor dispersibility, so that only a limited amount of titanium dioxide can contribute to light absorption, which results in deterioration in photoelectric conversion efficiency of the solar batteries.

Further, in the case where titanium dioxide is used as an electrode material for lithium ion batteries or a raw material of dielectrics, there is an increasing demand for ultrafine particles of titanium dioxide having a small primary particle diameter and an excellent affinity to other materials used in the electrode material for lithium ion batteries or the raw material of dielectrics.

Meanwhile, the method of producing titanium dioxide is generally classified into a gas phase method in which titanium tetrachloride is reacted oxygen or an oxidizing gas such as water vapor, and a liquid phase method in which titanium tetrachloride or titanyl sulfate is subjected to hydrolysis in a solution thereof.

In the gas phase method, titanium dioxide particles having a high crystallinity and an excellent dispersibility are obtained. However, since the reaction of the gas phase method is conducted at a high temperature exceeding 500°C, grain growth or sintering between particles tend to proceed, so that it is difficult to efficiently obtain titanium dioxide having a high specific surface area (Patent Document 1). On the other hand, in the liquid phase method, titanium dioxide is produced in a temperature range of from normal temperature to about 300°C at the highest, so that grain growth is suppressed, and ultrafine particles of titanium dioxide is likely to be produced.

As an example of the method of obtaining titanium dioxide having a high dispersibility by a liquid phase method, there has been reported such a method in which a surface of titanium dioxide is modified with silica, alumina or an organic compound as a dispersant for the purpose of maintaining a dispersibility of a slurry thereof for a long period of time.

However, the above liquid phase method using these dispersants might be unsuitable for use in some application fields since the dispersants as impurities are added to titanium dioxide. For example, in the case where titanium dioxide is used in the applications such as a raw material of dielectrics, a material for solar batteries and a photocatalyst, if there are present corrosive components such as chlorine, a base material used therein tends to be corroded or suffer from change in properties. Therefore, in such a case, it is required that the content of chlorine in titanium dioxide is reduced. In addition, in the applications such as an electrode material or a raw material of dielectrics, impurities such as iron (Fe), aluminum (Al), silicon (Si) and sulfur (S) contained in these materials must be minimized, because the inclusion of these impurities gives adverse influence on electrical properties of these materials. In addition, in the case where titanium dioxide is used in the applications of a photocatalyst and a material for solar batteries, Fe contained in titanium dioxide tends to cause undesirable coloration of these materials. Therefore, titanium dioxide containing Fe is unsuitable for use in the applications requiring a good transparency, whereas, titanium dioxide containing other components such as Al and S in a large amount tends to induce lattice defects and therefore cause deterioration in performance of the photocatalyst.

Also, Patent Document 2 discloses the method of producing ultrafine particles of titanium dioxide in which after titanium tetrachloride is hydrolyzed in water, the resulting product is separated and then dried. However, the method disclosed in Patent Document 2 is a method of obtaining brookite-type titanium dioxide, and the resulting titanium dioxide has a specific surface area as low as not more than 200 $m^2/g$ as measured by BET method and therefore an average primary particle diameter thereof is large.

Citation List

Patent Literature

Patent Document 1: JP 2006-265094A
Patent Document 2: JP 2004-043304A

SUMMARY OF THE INVENTION

PROBLEMS TO BE SOLVED BY THE INVENTION

An object of the present invention is to provide ultrafine particles of titanium dioxide having a small average primary particle diameter ($D_{BET}$) and a large water absorption, and a process for producing the ultrafine particles of titanium dioxide, as well as a composition, a material for solar batteries, a raw material of an electrode material for lithium ion batteries and a raw material of dielectrics containing the ultrafine particles of titanium dioxide.

MEANS FOR SOLVING THE PROBLEMS

The present inventors have made various researches to obtain ultrafine particles of titanium dioxide having a high dispersibility without modifying a surface of titanium dioxide with a dispersant such as silica. As a result, it has been found that in a process for production of titanium dioxide in which titanium tetrachloride is hydrolyzed, by adding sulfuric acid to the reaction solution, it is possible to obtain ultrafine particles of titanium dioxide having a fine average primary particle diameter ($D_{BET}$) and a large water vapor absorption (water absorption) as measured at a temperature of 25°C and a relative humidity of 90% (RH).

Thus, the ultrafine particles of titanium dioxide according to the present invention have a small average primary particle diameter ($D_{BET}$). In addition, the ultrafine particles of titanium dioxide according to the present invention have a large water absorption and therefore it is considered that the ultrafine particles of titanium dioxide exhibit a high hydrophilicity and an excellent dispersibility when dispersed in water. Further, it is considered that when using the ultrafine particles of titanium dioxide having a large water absorption according to the present invention as an electrode material for lithium ion batteries or a raw material of dielectrics, they exhibit a higher affinity to other raw materials, for example, metal salt compounds such as lithium salt compounds and barium salt compounds as compared to the conventionally known ultrafine particles of titanium dioxide.

That is, the present invention relates to the following aspects (1) to (14).

(1) A process for producing ultrafine particles of titanium dioxide, including:

a reaction step of subjecting titanium tetrachloride to hydrolysis reaction in water, and
a sulfuric acid addition step of adding sulfuric acid to the reaction solution after a reaction conversion rate of the titanium tetrachloride reaches not less than 80% and less than 100%.

(2) The process for producing ultrafine particles of titanium dioxide as described in the above aspect (1), wherein in the sulfuric acid addition step, the sulfuric acid is added at a temperature of from 45 to 75°C.

(3) The process for producing ultrafine particles of titanium dioxide as described in the above aspect (1) or (2), wherein a molar ratio (mol%) of the sulfuric acid to a sum of the titanium tetrachloride and the sulfuric acid [$H_2SO_4/(H_2SO_4 + TiCl_4)$] is from 4 to 33 mol%.

(4) The process for producing ultrafine particles of titanium dioxide as described in any one of the above aspects (1) to (3), wherein in the sulfuric acid addition step, an aqueous sulfuric acid solution having a sulfuric acid concentration of from 40 to 80% by mass is added.

(5) The process for producing ultrafine particles of titanium dioxide as described in any one of the above aspects (1) to (4), wherein in the reaction step, a temperature of an aqueous titanium tetrachloride solution is raised from a normal temperature.

(6) The process for producing ultrafine particles of titanium dioxide as described in any one of the above aspects (1) to (5), further including a dechlorination (Cl) step of separating titanium dioxide and hydrochloric acid produced in the hydrolysis reaction from each other using at least one material selected from the group consisting of an ultrafiltration membrane, a reverse osmosis membrane, an ion exchange resin and an electrodialysis membrane.

(7) The process for producing ultrafine particles of titanium dioxide as described in any one of the above aspects (1) to (6), further including a drying step of drying the ultrafine particles of titanium dioxide as produced.

(8) Ultrafine particles of titanium dioxide having an average primary particle diameter ($D_{BET}$) of from 2 to 20 nm as calculated in terms of a BET specific surface area thereof and a water absorption of from 16 to 35% by mass as measured at a temperature of 25°C and a relative humidity of 90% (RH).

(9) The ultrafine particles of titanium dioxide as described in the above aspect (8), wherein the ultrafine particles of titanium dioxide have an anatase content of from 90 to 100% by mass.

(10) The ultrafine particles of titanium dioxide as described in the above aspect (8) or (9), wherein the ultrafine particles of titanium dioxide have a residual chlorine content of 0.1% by mass or less and a residual sulfur content of 0.1% by mass or less.

(11) A composition including the ultrafine particles of titanium dioxide as described in any one of the above aspects (8) to (10), or the ultrafine particles of titanium dioxide produced by the process as described in any one of the above aspects (1) to (7).

(12) A material for solar batteries including the ultrafine particles of titanium dioxide as described in any one of the above aspects (8) to (10), or the ultrafine particles of titanium dioxide produced by the process as described in any one of the above aspects (1) to (7).

(13) A raw material of an electrode material for lithium ion batteries including the ultrafine particles of titanium dioxide as described in any one of the above aspects (8) to (10), or the ultrafine particles of titanium dioxide produced by the process as described in any one of the above aspects (1) to (7).

(14) A raw material of dielectrics including the ultrafine particles of titanium dioxide as described in any one of the above aspects (8) to (10), or the ultrafine particles of titanium dioxide produced by the process as described in any one of the above aspects (1) to (7).

EFFECT OF THE INVENTION

In accordance with the present invention, there are provided ultrafine particles of titanium dioxide which have a small average primary particle diameter and a larger water absorption than those of conventional titanium dioxides and a process for producing the ultrafine particles of titanium dioxide, as well as a composition, a material for solar batteries, a raw material of an electrode material for lithium ion batteries and a raw material of dielectrics which contain the ultrafine particles of titanium dioxide.

The titanium dioxide according to the present invention can be suitably used in the applications such as a photocatalyst, a material for solar batteries, an electrode material for lithium ion batteries and a raw material of dielectrics without need of specific deaggregation treatment and use of a dispersant, and therefore can exhibit a large industrial value.

PREFERRED EMBODIMENTS FOR CARRYING OUT THE INVENTION

[Ultrafine Particles of Titanium Dioxide]

The ultrafine particles of titanium dioxide according to the present invention have an average primary particle diameter ($D_{BET}$) of from 2 to 20 nm as calculated in terms of a BET specific surface area thereof, and a water absorption of from 16 to 35% by mass as measured at a temperature of 25°C and a relative humidity of 90% (RH).

<Average Primary Particle Diameter ($D_{BET}$)>

The ultrafine particles of titanium dioxide according to the present invention have an average primary particle diameter ($D_{BET}$) of from 2 to 20 nm, preferably from 2 to 18 nm, more preferably from 3 to 15 nm, still more preferably from 3 to 7.5 nm and further still more preferably from 3 to 6 nm as calculated in terms of a BET specific surface area thereof, more specifically as measured by the method described in Examples below. When the average primary particle diameter ($D_{BET}$) of the ultrafine particles of titanium dioxide is less than 2 nm, the resulting particles tend to be hardly dispersed owing to an excessively strong aggregating property thereof, and therefore tends to exhibit a poor handling property. When the average primary particle diameter ($D_{BET}$) of the ultrafine particles of titanium dioxide is more than 20 nm, the resulting particles tend to fail to sufficiently exhibit performances that are inherent to the ultrafine particles of titanium dioxide.

<Water Absorption>

The ultrafine particles of titanium dioxide according to the present invention have a water absorption of from 16 to 35% by mass, preferably from 18 to 32% by mass and more preferably from 19 to 30% by mass as measured at a temperature of 25°C and a relative humidity of 90% (RH) by the method described in detail hereinafter. When the water absorption of the ultrafine particles of titanium dioxide is less than 16% by mass, the effect of enhancing a dispersibility and an affinity of titanium dioxide tends to be hardly attained. When the water absorption of the ultrafine particles of titanium dioxide is more than 35% by mass, the resulting particles tend to have not only a large water absorption but also a large water desorption, and it is therefore necessary to control a weight thereof, which results in poor handing property thereof.

The ultrafine particles of titanium dioxide according to the present invention have a larger water absorption and a higher affinity to water as compared to conventionally known ultrafine particles of titanium dioxide. For this reason, it is considered that the ultrafine particles of titanium dioxide according to the present invention also have an excellent affinity to a metal salt compound as the other raw material having a high affinity to water which is contained in a raw material of dielectrics or an electrode material for lithium ion batteries.

<BET Specific Surface Area>

The ultrafine particles of titanium dioxide according to the present invention have a BET specific surface area of from 75 to 750 $m^2$/g, preferably from 83 to 750 $m^2$/g, more preferably from 100 to 500 $m^2$/g, still more preferably from 200 to 500 $m^2$/g and further still more preferably from 250 to 500 $m^2$/g as measured by the method described in Examples below.

<Anatase Content>

The titanium dioxide according to the present invention preferably contains an anatase crystal structure that is suitable as a raw material of dielectrics or a raw material of an electrode material for lithium ion batteries, as a main component. More specifically, the titanium dioxide according to the present invention preferably have an anatase content of 90% or more, more preferably 95% or more, and most preferably 100% as measured by the method described in Examples below. The anatase content of 90% or more in the titanium dioxide is desirable because the reaction to composite oxides such as the raw material of dielectrics, etc., proceeds efficiently.

<Contents of Elements>

The chlorine (Cl) content and sulfur (S) content of the titanium dioxide according to the present invention are respectively preferably 0.1% by mass or less, more preferably 0.08% by mass or less, and still more preferably 0.05% by mass or less. The lower limit of each of the chlorine (Cl) content and sulfur (S) content of the titanium dioxide is not particularly limited, and is preferably 0.0001% by mass or more from the viewpoint of low costs for the production process.

The content of each of elements including carbon (C), aluminum (Al), silicon (Si) and iron (Fe) is preferably less than 0.01% by mass, more preferably less than 0.005% by mass, and still more preferably less than 0.001% by mass. The lower limit of the content of each of the above elements is not particularly limited, and is preferably 0.0001% by mass or more from the viewpoint of low costs for the production process. In the case where the titanium dioxide is used as a raw material of dielectrics, etc., for example, in the case where the titanium dioxide is used as a raw material of barium titanate, it is necessary to strictly control a mixing ratio between a barium source and the titanium dioxide used upon synthesis of the raw material of dielectrics. In this case, if the content of impurities in the titanium dioxide is small, the resulting barium titanate tends to be hardly deviated from a composition as aimed. In addition, when the titanium dioxide has a small content of impurities therein, it is possible to not only reduce deviation of the above mixing ratio but also obtain a raw material of dielectrics having an excellent dielectric characteristic.

[Process for Producing Ultrafine Particles of Titanium Dioxide]

Next, the process for producing ultrafine particles of titanium dioxide according to the present invention is explained. The process for producing ultrafine particles of titanium dioxide according to the present invention includes a reaction step of subjecting titanium tetrachloride to hydrolysis reaction in water; and a sulfuric acid addition step of adding sulfuric acid to the reaction solution after a reaction conversion rate of the titanium tetrachloride reaches not less than 80% and less than 100%.

Also, according to the present invention, by controlling the reaction temperature and reaction conversion rate to the respective specific ranges, it is possible to obtain ultrafine particles of titanium dioxide having a large specific surface area and a large water absorption. The process of the present invention preferably includes, in addition to the above reaction step and sulfuric acid addition step, at least one step selected from the group consisting of a cooling step of cooling a reaction solution obtained after the sulfuric acid addition step, a dechlorination (Cl) step of removing chlorine, a step of separating the ultrafine particles of titanium dioxide from a slurry of titanium dioxide, and a step of drying the ultrafine particles of titanium dioxide thus separated.

Next, the respective steps are described in more detail.

<Reaction Step>

In the reaction step, titanium tetrachloride is subjected to hydrolysis reaction in water.

The hydrolysis reaction of titanium tetrachloride in water results in production of titanium hydroxide. Then, titanium hydroxide is subjected to polycondensation to produce cores of titanium dioxide, and growth of the cores of titanium dioxide results in production of primary particles of titanium dioxide. The main crystal structure of titanium dioxide thus produced is an anatase type and a rutile type. In the initial reaction stage, the anatase type crystal structure is produced, and then becomes changed into a rutile type crystal structure as a stable phase thereof by the action of hydrochloric acid.

In the reaction step, titanium tetrachloride may be mixed with water to subject the resulting mixture to hydrolysis reaction. However, it is preferred that an aqueous titanium tetrachloride solution is previously prepared and then mixed with water to subject the resulting mixed solution to hydrolysis reaction. The latter method has such an advantage that control of the hydrolysis reaction rate is facilitated.

In addition, in the reaction step, it is preferred that titanium tetrachloride or the aqueous titanium tetrachloride solution is added dropwise to water and mixed therewith. The dropwise addition of titanium tetrachloride or the aqueous titanium tetrachloride solution to water enables more uniform mixing of titanium tetrachloride or the aqueous titanium tetrachloride solution with water.

In the reaction step of the process according to the present invention, after titanium tetrachloride or the aqueous titanium tetrachloride solution is mixed with water in a reaction vessel, the resulting mixture is preferably subjected to hydrolysis reaction at at temperature of from 45 to 75°C, more preferably from 50 to 75°C and still more preferably 50 to 70°C. When the reaction temperature is 45°C or higher, the hydrolysis reaction can proceed at a practical reaction rate, whereas when the reaction temperature is 75°C or lower, excessively rapid progress of the reaction can be suppressed, so that the effect of sulfuric acid added in the subsequent sulfuric acid addition step can be sufficiently exhibited.

In the case where the aqueous titanium tetrachloride solution is mixed with water to conduct a hydrolysis reaction thereof, the concentration of titanium (Ti) contained in the aqueous titanium tetrachloride solution is preferably from 5 to 25% by mass, more preferably from 10 to 20% by mass, and still more preferably from 15 to 20% by mass. When the concentration of titanium (Ti) contained in the aqueous titanium tetrachloride solution is 5% by mass or more, titanium hydroxide is hardly precipitated at room temperature, which is desirable from the viewpoint of storage thereof. On the other hand, when the concentration of titanium (Ti) contained in the aqueous titanium tetrachloride solution is 25% by mass or less, aggregated particles are hardly produced, which is also desirable from the viewpoint of storage thereof.

Also, the concentration of titanium (Ti) contained in the reaction solution prepared by mixing the aqueous titanium tetrachloride solution with water is preferably from 0.05 to 10% by mass, more preferably from 1 to 5% by mass, still more preferably from 1 to 3% by mass, and further still more preferably from 1 to 2% by mass. When the concentration of titanium (Ti) contained in the reaction solution is 0.05% by mass or more, the aimed product can be produced with a high productivity, whereas when the concentration of titanium (Ti) contained in the reaction solution is 10% by mass or less, deterioration in yield of the aimed product owing to a low reactivity that will be caused by increase in the concentration of Ti can be suppressed.

In general, as the method of producing titanium dioxide by hydrolysis of titanium tetrachloride, there may be used the method in which after mixing water with titanium tetrachloride or the aqueous titanium tetrachloride solution, the resulting mixed solution is heated from a normal temperature to conduct a hydrolysis reaction thereof. In this case, uniform production of cores of titanium dioxide is caused owing to uniform distribution of a concentration of titanium tetrachloride in the solution, and the hydrolysis reaction proceeds at a relatively slow reaction rate because the hydrolysis depends upon a temperature rise rate or a heating temperature. The temperature of the aqueous titanium tetrachloride solution before heated is not particularly limited, and is preferably 40°C or lower, more preferably 30°C or lower, still more preferably 25°C or lower, and further still more preferably 20°C or lower.

The temperature rise rate is preferably from 0.1 to 0.8°C/min, more preferably 0.2 to 0.7°C/min, still more preferably from 0.3 to 0.6°C/min, and further still more preferably from 0.35 to 0.45°C/min. When the temperature rise rate is 0.1°C/min or higher, the hydrolysis reaction can proceed at a practical reaction rate, thereby ensuring a good productivity. When the temperature rise rate is as slow as 0.8°C/min or lower, production of cores of titanium dioxide is more dominant than growth of particles thereof, so that particles having a specific surface area of 200 $m^2$/g or more are likely to be obtained.

When the mixture prepared by mixing water with titanium tetrachloride or the aqueous titanium tetrachloride solution is continuously heated for a while, white turbidity is observed to obtain particles. The reaction is rapidly initiated, and the number of cores produced is increased at a a temperature of from 45 to 75°C to thereby obtain fine particles having a specific surface area of 200 $m^2$/g or more.

As the stirring apparatus used in the above mixing step, there may be mentioned extensively used ordinary rotary blade stirring apparatuses which may be equipped with rotary blades having a general shape such as a propeller shape, a turbine shape and a comb shape. Further, in order to enhance a mixing power, two or more stirring apparatuses may be installed in the reaction vessel, or the stirring apparatus may be further equipped with a baffle. In addition, as the reaction vessel, there may be used not only a batch reaction vessel, but also a continuous tank type reaction vessel in which titanium tetrachloride and water are continuously charged into continuous reaction tanks connected to each other, and the reaction solution is withdrawn on the side opposed to a charging port, or there may also be used a tube-type reaction vessel.

<Sulfuric Acid Addition Step>

In the above reaction step, at the time at which the reaction conversion rate of titanium tetrachloride reaches 80% or more, preferably 85% or more, more preferably 90% or more, still more preferably 95% or more, and further still more preferably 97% or more, an aqueous sulfuric acid solution is added to the reaction solution. When the reaction conversion rate of titanium tetrachloride is less than 80%, the reaction fails to proceed sufficiently, so that the effect of sulfuric acid added in the sulfuric acid addition step tends to be hardly exhibited to a sufficient extent.

In the sulfuric acid addition step, sulfuric acid is added at a temperature of from 45 to 75°C. When the temperature upon addition of sulfuric acid is 45°C or higher, the hydrolysis of titanium tetrachloride can proceed sufficiently, whereas when the temperature upon addition of sulfuric acid is 75°C or lower, it is possible to facilitate control of the temperature upon addition of the aqueous sulfuric acid solution. From these viewpoints, the temperature upon addition of sulfuric acid is preferably from 50 to 75°C, more preferably from 60 to 75°C, and still more preferably from 65 to 75°C.

The concentration of sulfuric acid in the aqueous sulfuric acid solution added in the sulfuric acid addition step is preferably from 40 to 80% by mass, more preferably from 45 to 65% by mass, still more preferably from 45 to 60% by mass, and further still more preferably from 45 to 55% by mass. When the concentration of sulfuric acid in the aqueous sulfuric acid solution is 40% by mass or more, it is possible to control a temperature of the reaction solution upon adding the aqueous sulfuric acid solution thereto so as not to deviate from the above temperature range of from 45 to 75°C. On the other hand, when the concentration of sulfuric acid in the aqueous sulfuric acid solution is 80% by mass or less, it is possible to prevent occurrence of bumping of the reaction solution, etc., upon adding the aqueous sulfuric acid solution thereto.

The aqueous sulfuric acid solution added may be prepared by mixing commercially available concentrated sulfuric acid with water, or may be prepared from commercially available dilute sulfuric acid, and the method of preparing the aqueous sulfuric acid solution is not particularly limited.

The molar ratio (mol%) of sulfuric acid to a sum of titanium tetrachloride and sulfuric acid [$H_2SO_4/(H_2SO_4 + TiCl_4)$] is preferably from 4 to 33 mol%. When the molar ratio is 33 mol% or less, removal of sulfuric acid is facilitated, so that the increase in $SO_4$ components as impurities in the resulting product can be prevented, and the obtained product can be suitably used without particular limitation to its applications. On the other hand, when the molar ratio is 4 mol% or more, the effect of sulfuric acid added can be readily exhibited. The molar ratio of sulfuric acid to a sum of titanium tetrachloride and sulfuric acid is more preferably from 8 to 33 mol%, still more preferably from 16 to 33 mol%, and further still more preferably from 20 to 28 mol%.

<Cooling Step>

The reaction solution obtained after the addition of sulfuric acid is preferably cooled to 60°C or lower in order to obtain titanium dioxide having an anatase content of 90% or higher. The cooling step may also contribute to production of a rutile-type crystal. As the period of time for which the reaction solution is held at a temperature of 60°C or higher becomes shorter, the change of the crystal form of titanium dioxide from an anatase type to a rutile type can be more effectively suppressed, thereby enhancing an anatase content of the resulting titanium dioxide. In general, the rutile-type crystal particles have a surface that is more hydrophobic than that of the anatase-type crystal particles and therefore tend to be readily aggregated together and deteriorated in dispersibility.

In the cooling step of the process according to the present invention, the cooling method used therein is not particularly limited, and there may be adopted various cooling methods such as use of a heat exchanger, direct introduction of a liquid such as chilled water and liquefied nitrogen into the reaction vessel, introduction of solids such as ice and dry ice into the reaction vessel, and blowing of gases such as $N_2$ and air into the reaction vessel.

<Dechlorination (Cl) Step>

In the dechlorination (Cl) step of the process according to the present invention, hydrochloric acid generated by the hydrolysis of titanium tetrachloride and sulfuric acid ions added are removed. As the method of removing the hydrochloric acid, there is preferably used a method of replacing the hydrochloric acid with pure water by using an ultrafiltration membrane or a reverse osmosis membrane, a method of removing chlorine ions by using an electrodialysis membrane or an ion exchange resin, or a combination of these methods. These methods enables removal of not only chlorine ions but also other anions such as sulfuric acid ions.

When subjecting the reaction solution to the dechlorination (Cl) treatment, it is possible to obtain ultrafine particles of titanium dioxide having a high dispersibility, a less impurity content and a high anatase content.

The dechlorination (Cl) step is preferably carried out subsequently to the cooling step or the sulfuric acid addition step, more preferably subsequently to the cooling step.

<Filtration Step and Drying Step>

When subjecting the reaction solution obtained after the dechlorination (Cl) step to filtration and drying the resulting cake at a temperature of from 50 to 200°C, it is possible to produce the ultrafine particles of titanium dioxide according to the present invention in a suitable manner.

[Composition, Material for Solar Batteries, Raw Material of Electrode Material for Lithium Ion Batteries, and Raw Material of Dielectrics]

The composition according to the present invention contains the above ultrafine particles of titanium dioxide. Also, the material for solar batteries, the raw material of an electrode material for lithium ion batteries and the raw material of dielectrics respectively contain the above ultrafine particles of titanium dioxide.

That is, the ultrafine particles of titanium dioxide according to the present invention have a small average primary particle diameter ($D_{BET}$) and a large water absorption and therefore can be suitably used as a material for solar batteries, a raw material of an electrode material for lithium ion batteries and a raw material of dielectrics.

EXAMPLES

The present invention will be described in more detail below with reference to the following Examples and Comparative Examples. However, these Examples, etc., are only illustrative and not intended to limit the invention thereto. Incidentally, in the following Examples and Comparative Examples, various properties of titanium dioxide, a reaction conversion rate of titanium tetrachloride, etc., were measured and evaluated by the following methods.

[Evaluation Methods]

<Measurement of Specific Surface Area>

The specific surface area S ($m^2$/g) was measured by one-point BET method using a specific surface area meter (Model No. "FlowSorb II, 2300") available from Shimadzu Corp.

<Measurement of Average Primary Particle Diameter ($D_{BET}$)>

The specific surface area S ($m^2$/g) of titanium dioxide was measured by one-point BET method, and the average primary particle diameter $D_{BET}$ (nm) thereof was calculated from the following formula (1).

$$D_{BET} = 6000/(S \times \rho) \qquad (1)$$

In the formula (1), $\rho$ represents a density (g/$cm^3$) of titanium dioxide. In the titanium dioxide according to the present invention which contains an anatase as a main component, $\rho$ is set to 4.0 ($\rho = 4.0$).

<Measurement of Water Absorption>

Ten grams of titanium dioxide was placed in a petri dish and dried under reduced pressure at 120°C for 2 h in a constant temperature oven to measure a weight of titanium dioxide thus dried. Thereafter, the titanium dioxide was allowed to stand in a thermo-hygrostat maintained at a temperature of 25°C and a relative humidity of 90% (RH) for 5 h or longer to measure a weight of the titanium dioxide having reached a water vapor absorption equilibrium. The weight of water absorbed in the titanium dioxide was calculated from the difference between the thus measured weight values. Next, the water absorption (mass%) of titanium dioxide was calculated from the following formula (2).

$$\text{Water Absorption (mass\%)} = \text{weight of water absorbed/weight of}$$

$$\text{titanium dioxide before absorption test} \times 100 \qquad (2)$$

<Measurement of Anatase Content>

Dried particles of titanium dioxide were subjected to powder X-ray diffraction measurement to measure a peak height corresponding to an anatase-type crystal (hereinafter referred to merely as "Ha"), a peak height corresponding to a brookite-type crystal (hereinafter referred to merely as "Hb") and a peak height corresponding to a rutile-type crystal (hereinafter referred to merely as "Hr"). The anatase content of titanium dioxide was calculated from these measured values according to the following formula (3).

$$\text{Anatase Content (\%)} = \{Ha/(Ha + Hb + Hr)\} \times 100 \qquad (3)$$

The powder X-ray diffraction measurement was carried out using a measuring apparatus "X' pert PRO" available from Panalytical Co., Ltd., and further by using copper as a target and Cu-K$\alpha_1$ ray under the following conditions: tube voltage: 45 kV; tube current: 40 mA; measuring range: $2\theta = 10$ to 80°; sampling width: 0.0167°; scanning speed: 0.0192°/s.

<Elemental Analysis>

In the following Examples and Comparative Examples, contents of chlorine (Cl), carbon (C), sulfur (S), iron (Fe), aluminum (Al) and silicon (Si) were measured by the following methods.

Chlorine (Cl): A solution prepared by adding an aqueous hydrofluoric acid solution to titanium dioxide and heating the obtained mixture with a microwave to dissolve titanium dioxide therein was subjected to potentiometric titration using silver nitrate.
Sulfur (S): Measured by high-frequency induction furnace combustion/infrared absorption method.
Carbon (C): Measured by high-frequency induction furnace combustion/infrared absorption method.
Iron (Fe): Measured by atomic absorption method.
Aluminum (Al) and silicon (Si): Measured by fluorescent X-ray analysis (XRF) method.

<Measurement of Reaction Conversion Rate of Titanium Tetrachloride>

In the hydrolysis reaction of titanium tetrachloride, the reaction solution was sampled and subjected to filtration to remove titanium dioxide produced therefrom. The resulting filtrate was subjected to ICP emission spectral analysis to measure an intensity of Ti. In addition, an aqueous titanium (Ti) solution having a previously known concentration was also subjected to ICP emission spectral analysis to prepare a calibration curve showing a relationship between an intensity of Ti and a concentration of Ti. The concentration of titanium (Ti) in the remaining aqueous titanium tetrachloride solution was determined from the above intensity of Ti in the filtrate and the thus prepared calibration curve.

Further, the concentration of unreacted Ti in the mixed solution was calculated from the amount of ion-exchanged water used and the amount of the aqueous titanium tetrachloride solution, and the reaction conversion rate of titanium tetrachloride was calculated from the concentrations of Ti before and after the reaction.

Example 1

A reaction vessel equipped with a comb-type stirrer was charged with 690 mL of ion-exchanged water. While stirring the ion-exchanged water at about 300 rpm, 50 g of an aqueous titanium tetrachloride solution maintained at room temperature (20°C) (concentration of Ti: 18% by mass) was added dropwise thereto, and the contents of the reaction vessel were stirred and mixed with each other. After adding the aqueous titanium tetrachloride solution into the reaction vessel, the contents of the reaction vessel were heated at a temperature rise rate of 0.4°C/min until reaching 70°C. At that time, the reaction solution was sampled to measure a reaction conversion rate of titanium tetrachloride. As a result, it was confirmed that the reaction conversion rate of titanium tetrachloride was 95%. The reaction time is shown in Table 1.

Thereafter, 10 g of a dilute sulfuric acid having a previously controlled concentration (concentration: 50% by mass) was added into the reaction vessel. After completing addition of the dilute sulfuric acid, the resulting reaction solution was cooled to 60°C or lower in an ice bath. Successively, hydrochloric acid and sulfuric acid ions produced by the reaction were removed by an electrodialyser, thereby obtaining a slurry of titanium dioxide. The thus obtained slurry of titanium dioxide was dried using a dryer at 100°C, and then deaggregated in a mortar to obtain titanium dioxide as aimed. The measurement results, etc., are shown in Table 1.

Example 2

The same procedure as in Example 1 was repeated except that the heating after charging titanium tetrachloride was conducted at a temperature rise rate of 0.2°C/min and continued until reaching 55°C, and at the time at which the reaction conversion rate of titanium tetrachloride reached 92%, sulfuric acid was added, thereby obtaining titanium dioxide. The measurement results, etc., are shown in Table 1.

Example 3

The same procedure as in Example 1 was repeated except that the heating after charging titanium tetrachloride was conducted at a temperature rise rate of 0.1°C/min and continued until reaching 45°C, and at the time at which the reaction conversion rate of titanium tetrachloride reached 90%, sulfuric acid was added, thereby obtaining titanium dioxide. The measurement results, etc., are shown in Table 1.

Comparative Example 1

The same procedure as in Example 1 was repeated except that the heating after charging titanium tetrachloride was conducted at a temperature rise rate of 0.1°C/min and continued until reaching 40°C, and at the time at which the reaction conversion rate of titanium tetrachloride reached 75%, sulfuric acid was added, thereby obtaining titanium dioxide. The measurement results, etc., are shown in Table 1.

Comparative Example 2

The same procedure as in Example 1 was repeated except that the heating after charging titanium tetrachloride was conducted at a temperature rise rate of 0.4°C/min and continued until reaching 80°C at which the reaction conversion rate of titanium tetrachloride was 97%, and then no sulfuric acid was added, thereby obtaining titanium dioxide. The measurement results, etc., are shown in Table 1.

Comparative Example 3

A reaction vessel equipped with a comb-type stirrer was charged with 690 mL of ion-exchanged water, and the ion-exchanged water was heated to 95°C. While stirring the ion-exchanged water at about 300 rpm and maintaining a temperature thereof at 95°C, 50 g of an aqueous titanium tetrachloride solution maintained at room temperature (20°C) (concentration of Ti: 18% by mass) was added dropwise thereto over 30 s, and the contents of the reaction vessel were stirred and mixed with each other, and held at 95°C for 4 min. The subsequent procedure was conducted in the same manner as in Example 1 except that no sulfuric acid was added to the reaction solution, and the contents of the reaction vessel was cooled to 50°C in an ice bath over less than 1 min (cooled to 60°C over 40 s), thereby obtaining titanium dioxide. The measurement results, etc., are shown in Table 1.

TABLE 1

| | Reaction conversion rate of titanium tetrachloride [%] | Anatase content [%] | Reaction time [min] | BET specific surface area [m²/g] | Average primary particle diameter $D_{BET}$ [nm] | Water absorption [mass%] | Contents of elements [mass%] | | | | | |
|---|---|---|---|---|---|---|---|---|---|---|---|---|
| | | | | | | | Cl | S | C | Fe | Al | Si |
| Example 1 | 95 | 95 | 125 | 355 | 4.2 | 24 | 0.01 | 0.02 | <0.01 | <0.001 | <0.001 | <0.01 |
| Example 2 | 92 | 97 | 175 | 280 | 5.4 | 21 | 0.02 | 0.03 | <0.01 | <0.001 | <0.001 | <0.01 |
| Example 3 | 90 | 95 | 250 | 255 | 5.9 | 20 | 0.01 | 0.03 | <0.01 | <0.001 | <0.001 | <0.01 |
| Comparative Example 1 | 75 | 100 | 200 | 270 | 5.6 | 12 | 0.05 | 0.04 | <0.01 | <0.001 | <0.001 | <0.01 |
| Comparative Example 2 | 97 | 90 | 100 | 301 | 5.0 | 13 | 0.02 | <0.01 | <0.01 | <0.001 | <0.001 | <0.01 |
| Comparative Example 3 | 96 | 100 | 4 | 330 | 4.5 | 13 | 0.02 | <0.01 | <0.01 | <0.001 | <0.001 | <0.01 |

From the results shown in Table 1, it was confirmed that by adding sulfuric acid after the reaction conversion rate of titanium tetrachloride exceeded 90%, it was possible to produce ultrafine particles of titanium dioxide having not only a large specific surface area but also a large water absorption as measured at a temperature of 25°C and a relative humidity of 90% (RH). In Comparative Example 1 in which the aqueous sulfuric acid solution was added at the time at which the reaction conversion rate of titanium tetrachloride was still as low as 75%, although the resulting titanium dioxide had a specific surface area of 270 m$^2$/g similarly to that of Example 1, the water absorption of the titanium dioxide was low.

Also, in Comparative Example 2 in which no sulfuric acid was added, although the obtained titanium dioxide was in the form of ultrafine particles having a specific surface area of 301 m$^2$/g, the water absorption thereof was as low as about a half of the water absorption of the titanium dioxide obtained in the Examples. In Comparative Example 3, although the obtained titanium dioxide had a larger specific surface area than those of the Examples 2 and 3, the water absorption thereof was low owing to no addition of sulfuric acid.

INDUSTRIAL APPLICABILITY

The ultrafine particles of titanium dioxide according to the present invention have a small average primary particle diameter (D$_{BET}$) and a large water absorption, and it is therefore considered that the ultrafine particles of titanium dioxide have a high hydrophilicity an a surface thereof, in particular, can exhibit an excellent affinity to auxiliary materials mixed in a material for solar batteries, a raw material of dielectrics, an electrode material for lithium ion batteries, etc. As a result, according to the present invention, there can be provided ultrafine particles of titanium dioxide having extremely useful properties.

**Claims**

1. A process for producing ultrafine particles of titanium dioxide, comprising:

   a reaction step of subjecting titanium tetrachloride to hydrolysis reaction in water, and
   a sulfuric acid addition step of adding sulfuric acid to the reaction solution after a reaction conversion rate of the titanium tetrachloride reaches not less than 80% and less than 100%.

2. The process for producing ultrafine particles of titanium dioxide according to claim 1, wherein in the sulfuric acid addition step, the sulfuric acid is added at a temperature of from 45 to 75°C.

3. The process for producing ultrafine particles of titanium dioxide according to claim 1 or 2, wherein a molar ratio (mol%) of the sulfuric acid to a sum of the titanium tetrachloride and the sulfuric acid [H$_2$SO$_4$/(H$_2$SO$_4$ + TiCl$_4$)] is from 4 to 33 mol%.

4. The process for producing ultrafine particles of titanium dioxide according to any one of claims 1 to 3, wherein in the sulfuric acid addition step, an aqueous sulfuric acid solution having a sulfuric acid concentration of from 40 to 80% by mass is added.

5. The process for producing ultrafine particles of titanium dioxide according to any one of claims 1 to 4, wherein in the reaction step, a temperature of an aqueous titanium tetrachloride solution is raised from 40°C or lower.

6. The process for producing ultrafine particles of titanium dioxide according to any one of claims 1 to 5, further comprising a dechlorination (Cl) step of separating titanium dioxide and hydrochloric acid produced in the hydrolysis reaction from each other using at least one material selected from the group consisting of an ultrafiltration membrane, a reverse osmosis membrane, an ion exchange resin and an electrodialysis membrane.

7. The process for producing ultrafine particles of titanium dioxide according to any one of claims 1 to 6, further comprising a drying step of drying the ultrafine particles of titanium dioxide as produced.

8. A composition comprising the ultrafine particles of titanium dioxide produced by the process as defined in any one of claims 1 to 7.

9. A material for solar batteries comprising the ultrafine particles of titanium dioxide produced by the process as defined in any one of claims 1 to 7.

**10.** A raw material of an electrode material for lithium ion batteries comprising the ultrafine particles of titanium dioxide produced by the process as defined in any one of claims 1 to 7.

**11.** A raw material of dielectrics comprising the ultrafine particles of titanium dioxide produced by the process as defined in any one of claims 1 to 7.

**Patentansprüche**

**1.** Verfahren zum Herstellen ultrafeiner Teilchen von Titandioxid, welches umfasst: eine Reaktionsstufe, in der Titantetrachlorid einer Hydrolysereaktion in Wasser unterworfen wird, und eine Schwefelsäurezugabestufe, in der Schwefelsäure zu der Reaktionslösung gegeben wird, nachdem die Reaktionsumwandlungsrate des Titantetrachlorids nicht weniger als 80 % und weniger als 100 % erreicht.

**2.** Verfahren zum Herstellen ultrafeiner Teilchen von Titandioxid nach Anspruch 1, wobei in der Schwefelsäurezugabstufe die Schwefelsäure bei einer Temperatur von 45 bis 75 °C zugegeben wird.

**3.** Verfahren zum Herstellen ultrafeiner Teilchen von Titandioxid nach Anspruch 1 oder 2, wobei das Molverhältnis (Mol-%) der Schwefelsäure zu der Summe des Titantetrachlorids und der Schwefelsäure [$H_2SO_4/(H_2SO_4 + TiCl_49$] 4 bis 33 Mol-% ist.

**4.** Verfahren zum Herstellen ultrafeiner Teilchen von Titandioxid nach einem der Ansprüche 1 bis 3, wobei in der Schwefelsäurezugabestufe eine wässrige Schwefelsäurelösung einer Schwefelsäurekonzentration von 40 bis 80 Massen-% zugegeben wird.

**5.** Verfahren zum Herstellen ultrafeiner Teilchen von Titandioxid nach einem der Ansprüche 1 bis 4, wobei in der Reaktionsstufe die Temperatur der wässrigen Titantetrachloridlösung von 40°C oder niedriger erhöht wird.

**6.** Verfahren zum Herstellen ultrafeiner Teilchen von Titandioxid nach nach einem der Ansprüche 1 bis 5, das außerdem eine Stufe zum Dechlorieren (Cl) umfasst, in der Titandioxid und Chlorwasserstoffsäure, die in der Hydrolysereaktion gebildet wird, voneinander getrennt werden, indem mindestens ein Material verwendet wird, das aus der Gruppe ausgewählt ist, die aus einer Ultrafiltrationsmembran, einer Umkehrosmosemembran, einem Ionenaustauscherharz und einer Elektrodialysemembran besteht.

**7.** Verfahren zum Herstellen ultrafeiner Teilchen von Titandioxid nach einem der Ansprüche 1 bis 6, das außerdem eine Trocknungsstufe umfasst, in der die ultrafeinen Teilchen von Titandioxid beim Herstellen getrocknet werden.

**8.** Zusammensetzung, welche die durch das Verfahren nach einem der Ansprüche 1 bis 7 hergestellten ultrafeinen Teilchen von Titandioxid umfasst.

**9.** Material für Solarbatterien, welches die durch das Verfahren nach einem der Ansprüche 1 bis 7 hergestellten ultrafeinen Teilchen von Titandioxid enthält.

**10.** Ausgangsmaterial für ein Elektrodenmaterial für Lithiumionenbatterien, welches die durch das Verfahren nach einem der Ansprüche 1 bis 7 hergestellten ultrafeinen Teilchen von Titandioxid enthält.

**11.** Ausgangsmaterial für Dielektrika, welches die durch das Verfahren nach einem der Ansprüche 1 bis 7 hergestellten ultrafeinen Teilchen von Titandioxid enthält.

**Revendications**

**1.** Procédé de production de particules ultrafines de dioxyde de titane, comprenant :

une étape de réaction consistant à soumettre du tétrachlorure de titane à une réaction d'hydrolyse dans de l'eau, et
une étape d'adjonction d'acide sulfurique consistant à ajouter de l'acide sulfurique à la solution réactionnelle après qu'un taux de conversion de réaction du tétrachlorure de titane ait atteint 80 % ou plus et 100 % ou moins.

**2.** Procédé de production de particules ultrafines de dioxyde de titane selon la revendication 1, dans lequel dans l'étape d'adjonction d'acide sulfurique, l'acide sulfurique est ajouté à une température de 45 à 75 °C.

**3.** Procédé de production de particules ultrafines de dioxyde de titane selon la revendication 1 ou 2, dans lequel un rapport molaire (% en mol) de l'acide sulfurique à une somme du tétrachlorure de titane et de l'acide sulfurique $[H_2SO_4/(H_2SO_4 + TiCl_4)]$ est de 4 à 33 % en mol.

**4.** Procédé de production de particules ultrafines de dioxyde de titane selon l'une quelconque des revendications 1 à 3, dans lequel dans l'étape d'adjonction d'acide sulfurique, une solution aqueuse d'acide sulfurique ayant une concentration d'acide sulfurique de 40 à 80 % en masse est ajoutée.

**5.** Procédé de production de particules ultrafines de dioxyde de titane selon l'une quelconque des revendications 1 à 4, dans lequel dans l'étape de réaction, une température d'une solution aqueuse de tétrachlorure de titane est augmentée de 40 °C ou moins.

**6.** Procédé de production de particules ultrafines de dioxyde de titane selon l'une quelconque des revendications 1 à 5, comprenant en outre une étape de déchloration (Cl) consistant à séparer le dioxyde de titane et l'acide chlorhydrique produits dans la réaction d'hydrolyse l'un de l'autre en utilisant au moins un matériau choisi dans le groupe constitué d'une membrane d'ultrafiltration, d'une membrane à osmose inverse, d'une résine échangeuse d'ions et d'une membrane d'électrodialyse.

**7.** Procédé de production de particules ultrafines de dioxyde de titane selon l'une quelconque des revendications 1 à 6, comprenant en outre une étape de séchage consistant à sécher les particules ultrafines de dioxyde de titane telles que produites.

**8.** Composition comprenant les particules ultrafines de dioxyde de titane produites par le procédé selon l'une quelconque des revendications 1 à 7.

**9.** Matériau pour batteries solaires comprenant les particules ultrafines de dioxyde de titane produites par le procédé selon l'une quelconque des revendications 1 à 7.

**10.** Matière première d'un matériau d'électrode pour batteries au lithium-ion comprenant les particules ultrafines de dioxyde de titane produites par le procédé selon l'une quelconque des revendications 1 à 7.

**11.** Matière première de diélectriques comprenant les particules ultrafines de dioxyde de titane produites par le procédé selon l'une quelconque des revendications 1 à 7.

**REFERENCES CITED IN THE DESCRIPTION**

**Patent documents cited in the description**

- JP 2006265094 A

- JP 2004043304 A